Europäisches Patentamt

**European Patent Office**

Office européen des brevets

(19)

(11) Numéro de publication: **0 053 213**
**B1**

(12)
# FASCICULE DE BREVET EUROPEEN

(45) Date de publication du fascicule du brevet:
**04.04.84**

(51) Int. Cl.³: **H 01 L 29/94**, G 01 R 31/26

(21) Numéro de dépôt: **80430026.7**

(22) Date de dépôt: **28.11.80**

(54) **Nouveau condensateur à structure de quadripôle dont l'intégrité peut être contrôlée à l'aide de tests en courant continu.**

(43) Date de publication de la demande:
**09.06.82 Bulletin 82/23**

(45) Mention de la délivrance du brevet:
**04.04.84 Bulletin 84/14**

(84) Etats contractants désignés:
**DE FR GB IT NL**

(56) Documents cités:
**US - A - 3 611 070**
**US - A - 4 001 869**

**L'ONDE ELECTRIQUE, vol. 58, no. 12 décembre 1978 Paris, FR J.M. LAGORSSE et al.: "Exploration et contrôle d'une technologie MOS LSI par'véhicule-test'"', pages 823-829**
**IEEE TRANSACTIONS ON ELECTRON DEVICES, vol. ED-21, no. 7, juillet 1974 New York, US M.Y. DARWISH: "Measurement of the mobility and concentration of carriers in diffused zones in Si with a gate controlled structure" pages 397-402**

(73) Titulaire: **International Business Machines Corporation, Old Orchard Road, Armonk, N.Y. 10504 (US)**

(84) Etats contractants désignés: **DE GB IT NL**

(73) Titulaire: **Compagnie IBM FRANCE, 5 Place Vendôme, F-75000 Paris 1er (FR)**

(84) Etats contractants désignés: **FR**

(72) Inventeur: **Delaporte, François-Xavier, 36 chemin de Saint-Laurent, 06800 Cagnes-sur-Mer (FR)**
Inventeur: **Pantani, Jean-Pierre, 239 Boulevard du Mont Boron, Le Mykonos B5 06300 Nice (FR)**

(74) Mandataire: **Klein, Daniel Jacques Henri, Compagnie IBM France Département de Propriété Industrielle, F-06610 La Gaude (FR)**

# Nouveau condensateur à structure de quadripole dont l'intégrité peut être controlée à l'aide de tests en courant continu

La présente invention concerne une nouvelle structure de condensateur appropriée pour être intégrée selon les techniques monolithiques ou hybrides; elle concerne plus particulièrement une structure de condensateur de type MOS, conçue sous la forme d'un quadripole et dont l'intégrité peut être contrôlée uniquement à l'aide de tests effectués en courants continus.

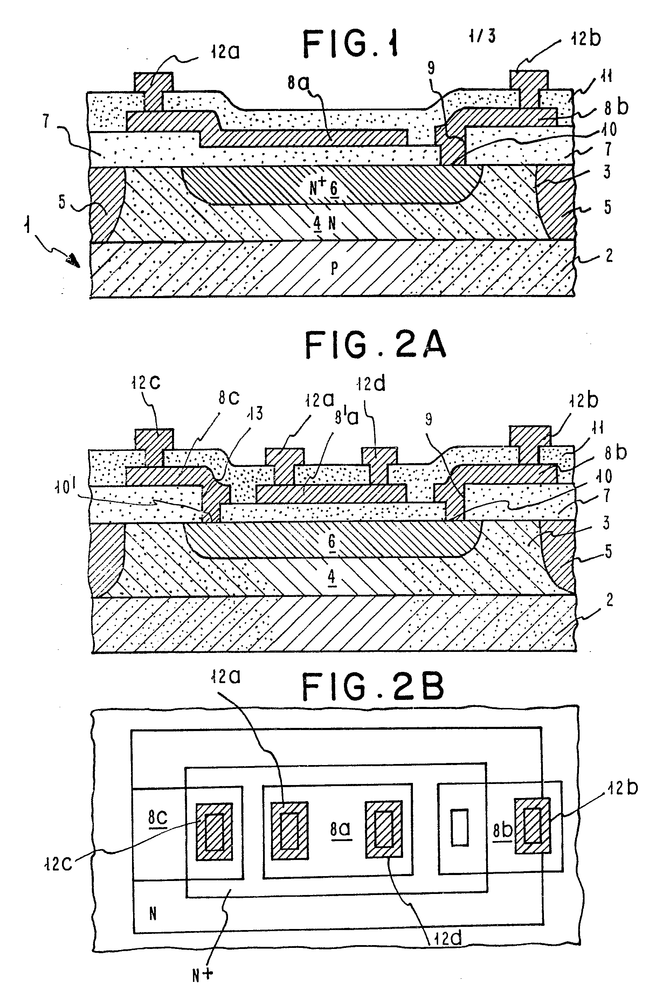

Le principe des condensateurs MOS est bien connu dans la technique, on pourra se référer par exemple à l'ouvrage de R. M. Warner, »Integrated Circuits, Design Principles and Fabrication« publié par Mc Graw-Hill, édition de 1965, page 253. Un condensateur de ce type est représenté sur la figure 1 où il porte la référence 1. Sur un substrat 2 de type P de résistivité $5\,\Omega \cdot$ cm, on fait croître une couche épitaxiale 3 de type N de résistivité $0,5\,\Omega \cdot$ cm, puis on réalise un caisson isolé 4 dans cette couche en formant des murs d'isolation 5 de type P. Dans ce caisson on forme, par diffusion une région 6 de type N, fortement dopée qui constitue la première électrode du condensateur. On forme une mince couche isolante 7 de $SiO_2$ (500 Å) sur le substrat selon une configuration désirée, qui constitue le diélectrique, puis on forme un film 8 métallique d'aluminium qui est déposé selon la configuration désirée sur la couche isolante. L'élément 8a est la seconde électrode du condensateur ou électrode supérieure. L'élément 8b assure la liaison électrique avec la première électrode à travers une ouverture 9 pratiquée dans la couche isolante 7. Les étapes sont renouvelées pour former la couche isolante 11 et les contacts 12a et 12b. On à montré sur la figure, une structure réalisée avec une métallurgie du type multicouches, d'autres modes de réalisation sont bien sûr possibles. La disposition des contacts de sortie 12a et 12b sont montrés sur la fig. 1. Les avantages de cette structure sont bien connus: la capacité n'est pas polarisée ce qui permet une grande flexibilité dans les applications et sa valeur reste constante, lors de l'application d'un signal alternatif. Aussi les structures de ce type sont-elles très largement utilisées dans l'industrie de la microélectronique.

Ces condensateurs MOS une fois fabriqués, selon les procédés classiques de la technologie des circuits intégrès, doivent subir différents tests pour s'assurer de leur intégrité. Les tests en courants continus (tests cc) se révèlent incapables de mettre en évidence les défauts au niveau de la métallurgie. On sait qu'avec les techniques d'intégration de type LSI ou VLSI d'aujourd'hui, les trous de contact peuvent avoir des diamètres inférieurs à 0,5 micron. La formation de ces trous (par ailleurs en très grand nombre) peut ne pas se faire ou leur nettoyage peut s'avérer insuffisant ou encore le métal peut avoir des difficultés pour venir en contact avec la surface du substrat au niveau de l'interface 10. Pour toutes ces raisons le contact au niveau de cet interface peut être défectueux ou inexistant. La qualité de ce contact ne peut être contrôlée par un test c-c en raison du défaut de continuité du chemin conducteur qui inclus l'élément 8b et la région 6 puisqu'il manque un circuit de retour. La région diffusée 6 peut également être absente ou décalée de sorte que, à travers le trou 9, le métal vienne en contact avec l'épitaxie 3, et non avec la région 6. Egalement, un défaut dans l'intégrité de la métallisation 8a (absence totale ou partielle) due par exemple à la présence de poussières au niveau des étapes photolithographiques, ne peut être contrôlé par les tests c-c. L'intégrité des condensateurs MOS se fait donc habituellement à partir de tests en courants alternatifs (test a-c) qui mesurent en fait la valeur de la capacité; ces tests sont reconnus être longs et coûteux. En effet, les valeurs des capacités MOS couramment utilisées restent généralement dans la gamme de 1 à 100 pf, avec des valeurs typiques de 10 pf, les circuits de tests (forme des impulsions) doivent être très performants et les connexions très soignées, sinon les capacités parasites masqueront les valeurs mesurées. D'où l'utilisation indispensable de câbles coaxiaux équilibrés qui font de ce test, une opération difficile lente et coûteuse. Une technique connue pour éviter ces tests a-c consistait à ne pas tester la capacité MOS en elle-même mais à la tester une fois la microplaquette montée sur le module. Cette technique présente un double inconvénient: d'une part elle augmente le nombre de fonctions à contrôler (qui sont rendues par ailleurs plus complexes) et d'autre part elle est plus coûteuse; en effet, si la microplaquette s'avère défectueuse elle conduit au rejet, du module tout entier. Les tests a-c peuvent être réalisés avec différents testeurs tels que ceux commercialisés par Teradyne, Fairchild, etc...

En réalité le coût de ces testeurs et de leur mise en oeuvre est tel que les fabricants de composants renoncent le plus souvent à contrôler ce paramètre d'intégrité, ce qui a pour inconvénient de laisser passer des pièces défectueuses dont le remplacement ultérieur en test final ou en clientèle est catastrophique.

A titre d'exemple, on sait que de nombreux circuits analogiques, tels que les amplificateurs opérationels, comportent au moins une capacité. On a observé dans des modules qui comportait un ou plusieurs amplificateurs, qu'une proportion d'un module défectueux sur cent était habituelle. Or, certaines machines complexes (autocommutateurs électroniques) nécessitent plusieurs centaines ou millions d'amplificateurs opérationels, ce qui signifie qu'un moyenne, toutes les machines présentent des défauts.

La présente invention a permis de diminuer par un facteur d'environ 20 le nombre de modules défectueux.

Par conséquent, le nombre de machines défectueuses en test final est considérablement réduit.

Pour arriver à cette situation plus favorable, le besoin s'est donc fait sentir de développer un procédé de test à partir d'une nouvelle structure qui permette le contrôle de son intégrité à partir de tests c-c.

Une nouvelle conception des condensateurs MOS a été développée par la demanderesse qui conduit à une structure dont l'intégrité des contacts et de la métallurgie peut être aisément contrôlée à l'aide de tests c-c exclusivement. Cette nouvelle structure se caractérise par une disposition qui rappelle celle des MOSFET. La liaison électrique avec la région de type N+ qui s'effectuait auparavant par un seul contact, s'effectue désormais par deux contacts disposés à deux extrémités de cette région. Comme il s'agit d'apprécier la qualité des contacts, les emplacements de ces derniers ont relativement peu d'importance. L'électrode supérieure est également munie de deux contacts disposés aux deux extrémités opposées de l'électrode. Celle-ci aura de préférence la forme d'une bande, éventuellement en forme de grecque. Enfin des moyens sont prévus pour appliquer et mesurer des courants à partir de ces quatre contacts. Fonctionellement la capacité est donc réalisée sous la forme réelle d'un quadripole.

Le principe de l'invention est d'application plus large, et un condensateur conforme aux enseignements de la présente invention peut être réalisé selon différentes technologies: monolithique, hybride, films minces, etc., et s'appliquer aux différents types de condensateurs: à jonction, MOS, etc. Un premier avantage de cette structure est sa compatibilité avec les procédés de fabrication standards, il n'y a aucune modification par rapport au procédé de fabrication de la structure MOS de la fig. 1, seuls les masques qui correspondent aux étapes de définition de la couche isolante et de la couche métallique, sont modifiés.

L'avantage principal procuré par cette structure est, comme on l'a écrit ci-dessus, la possibilité d'être testée en courant continu. Dans certains produits tels que les circuits d'interface, les générateurs de rampe, les amplificateurs opérationnels, . . ., les capacités MOS sont en très petit nombre mais elles jouent un rôle capital, aussi il est important de tester leur intégrité. L'ensemble des composants peut être contrôlé par des tests c-c, la présence d'une seule capacité nécessitait jusqu'alors l'application de tests a-c. La suppression de ces derniers grâce à la structure de la présente invention, est importante du point de vue du prix de revient des produits.

La fig. 1 représente schématiquement la structure classique d'un condensateur MOS de l'art antérieur.

La fig. 2 représente schématiquement une vue en coupe de la structure d'un condensateur MOS conforme à la présente invention.

La fig. 3 représente la vue de dessus d'un condensateur MOS conforme à la présente invention susceptible d'être utilisé dans l'industrie et le dispositif de test.

La fig. 4 représente un circuit d'interface connu qui comporte une capacité de compensation, qui peut être réalisée structurellement conforme à la présente invention.

La fig. 2 représente de façon très schématique une vue en coupe d'un condensateur conforme à la présente invention.

Dans cette figure, les éléments de la nouvelle structure qui sont pratiquement identiques à ceux de la structure montrée sur la fig. 1 portent les mêmes références. Le procédé de fabrication est rigoureusement le même dans les deux cas. La distinction se faisant au niveau des masques de fabrication aux étapes: première et deuxième oxydations et premier et deuxième niveaux de métallurgie. Les configurations des deux niveaux de métallurgie sont donc différents dans la nouvelle structure. Au premier niveau de métallurgie, une ouverture 13 est pratiquée et une liaison électrique supplémentaire 8c est établie avec la région N+ 6. Un contact 12c est établi avec l'élément conducteur 8c. On peut donc tester la qualité des interfaces 10 et 10' en établissant la continuité électrique sur le chemin contact 12c — élément 8c — région 6 — élément 8b — contact 12b. De même la qualité de la métallisation constituant l'électrode supérieure (l'élément conducteur 8'a) peut facilement être contrôlée à partir des contacts 12a et 12d.

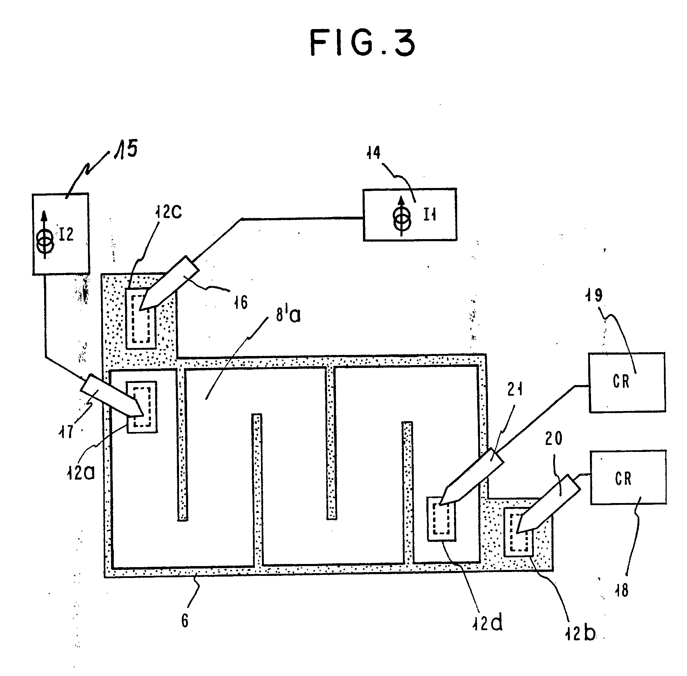

Sur la fig. 3 on a représenté un condensateur MOS typique qui met en oeuvre les enseignements de la présente invention. L'emplacement des contacts 12b et 12c importe peu tant qu'il s'agit de contrôler l'existence ou la qualité des contacts au niveau des interfaces 10 et 10', ou de l'existence de la région 6. En ce qui concerne le contrôle de l'intégrité de l'élément conducteur 8'a, le concepteur aura intérêt à utiliser une forme de grecque telle que celle qui est représentée, les défauts, dans la qualité de la métallisation seront plus aisément détectés. La région N+ 6 peut également être réalisée, si on le souhaite, sous la forme d'une grecque correspondante. Le test s'effectue de la façon suivante: deux générateurs de courants 14 et 15 fournissent respectivement un courant $I_1$ au contact 12c par la sonde 16, et un courant $I_2$ au courant 12a par la sonde 17. Parallèlement des circuits détecteurs de courants 18 et 19 reçoivent des courants correspondants. Le circuit 18 est relié au contact 12b par la sonde 20 et le circuit 19 au contact 12d par la sonde 21. L'absence de courant (ou un courant anormalement faible) est immédiatement détectée par l'un des circuits 18 ou 19, ce qui signale un défaut susceptible de causer le rejet du condensateur (ou de la microplaquette sur laquelle il a été intégré). Il faut comprendre que, généralement les contacts 12a, 12b, 12c et 12d, sont reliés à des bornes de sortie, correspondantes situées à la périphérie de la microplaquette, par des lignes conductrices. Le test s'effectue en réalité à partir de ces bornes. Les contacts de sortie du condensateur utilisables en a-c sont 12b ou 12c pour une électrode, 12a ou 12d l'autre électrode.

Le passage du courant dans les électrodes constitue une garantie de l'existence et du raccordement effectif du condensateur mais on peut aller plus loin et chercher à s'assurer que la valeur du condensateur est conforme à la valeur prévue.

Ceci peut se déduire de la valeur de la résistance des dipôles 12a vers 12d d'une part, 12b vers 12c d'autre part.

Si l'intégrité des surfaces a été affectée pour une raison quelconque, par exemple en raison de poussières sur un masque, les chemins de courant seront modifiés de façon substantielle et ceci se traduira par une anomalie au niveau de la mesure des résistances.

La comparaison avec un condensateur de référence indiquera si le condensateur en cours de test est intact quant à sa surface, ou pas.

Cette mesure de résistances peut se faire soit directement, soit par la méthode Kelvin, en mesurant la chute de tension aux bornes du dipôle par un courant donné injecté dans ce dipôle.

Quand la configuration du circuit s'y prête, le condensateur de la présente invention peut présenter une autre possibilité de test particulièrement avantageux. Dans cette configuration, le test d'intégrité peut ne pas nécessiter d'étape spécifique ni impliquer de connexion avec les bornes d'entrée et de sortie. Il s'agit d'inclure le condensateur dans la fonction réalisée et faire en sorte (éventuellement par une conception différente du circuit) que la fonctionnalité de cette dernière en courant continu soit comprise si l'intégrité du condensateur n'existe pas.

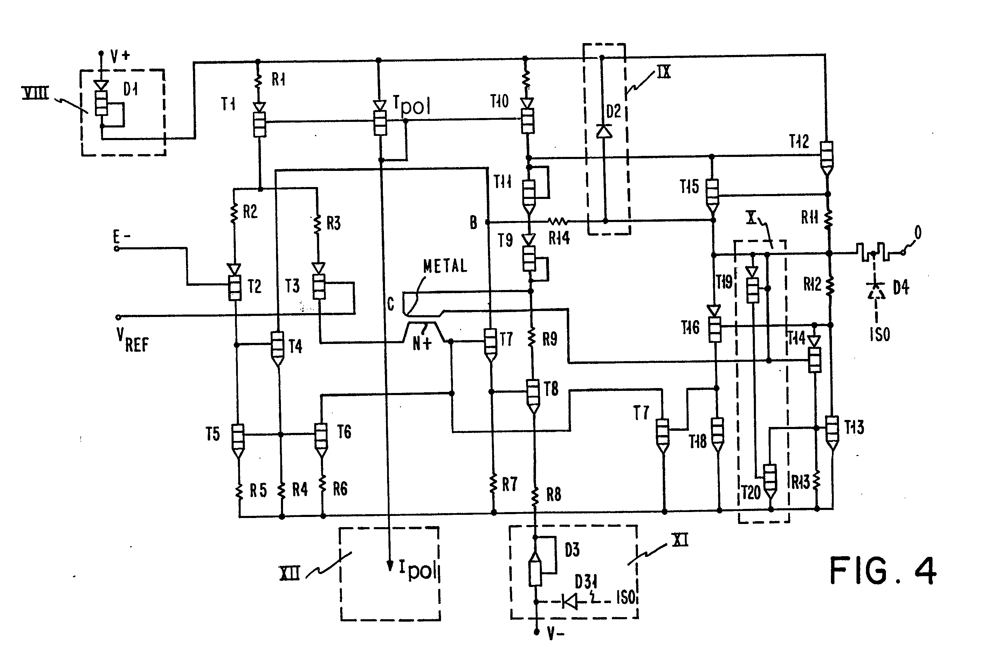

La fig. 4 représente le circuit d'interface de type CCITT V24 qui fait l'objet de la demande de brevet français No. 7 929 808 déposée par la demanderesse le 28 novembre 1979. Le circuit montré est identique à celui de la fig. 4 de ladite demande qui est incorporée ici par référence. La capacité C est montrée avec sa structure de dipôle, conforme aux enseignements de la présente invention. De très légères modifications ont été rendues nécessaires. D'une part, coupre de la ligne conductrice qui relie les transistors T3 et T6 et retour par la base de T7, pour assurer la continuité de l'électrode diffusée de type N+, et d'autre part utilisation de l'électrode métallique pour relier le collecteur de T9 à la base de T14. Avec cette configuration, il est inutile de tester la capacité C prise isolément, il suffit de tester la fonction »circuit d'interface« toute entière. On voit que si l'une ou l'autre des électrodes est détériorée, soit dans sa surface, soit dans ses contacts, la continuité du courant continu n'exise plus et la sortie du circuit reste soit toujours positive, soit toujours négative indépensamment du niveau des entrées.

Ainsi le test c-c de la fonction révèle la détérioration du condensateur sans nécessiter d'étapes de test spécifiques, ni l'accès direct aux bornes de sortie du condensateur ainsi réalisé. L'économie des quatre bornes de sortie, qui sans cela aurait été nécessaire pour le test du condensateur, est également appréciable.

## Revendications

1. Structure de condensateur approprié pour être intégrée selon les techniques monolithiques ou hybrides dont l'intégrité des contacts et de la métallurgie peut être contrôlée uniquement à l'aide de tests en courant continu du genre comportant:
une première couche conductrice formant la première électrode (6) et munie d'un premier contact (12b),
une seconde couche conductrice formant la seconde électrode (8a) et munie d'un second contact (12a),
une couche isolante (7) formant un diélectrique entre lesdites électrodes,
caractérisée en ce qu'elle comprend en outre:
un troisième contact (12c) avec la première couche conductrice coopérant avec le premier contact pour permettre le test de l'intégrité et la continuité de cette couche, pour un courant continu et
un quatrième contact (12d) avec la seconde couche conductrice, coopérant avec le second contact pour permettre le test de l'intégrité et la continuité de cette couche, par un courant continu.

2. Structure de condensateur selon la revendication 1 caractérisée en ce que ladite seconde couche conductrice affecte la forme d'une grecque, les contacts (12a) et (12d) étant disposés à ses deux extrémités.

3. Structure de condensateur selon la revendication 1 ou 2 caractérisée en ce que ladite première couche conductrice est une région semiconductrice (6) fortement dopée formée dans un caisson isolé (4) d'une couche épitaxiale (3).

4. Structure de condensateur selon la revendication 3 caractérisée en ce que ladite première couche affecte également une form de grecque correspondante à celle de la seconde couche.

## Patentansprüche

1. Zur Integration gemäß der hybrider beziehungsweise monolithischer Technik anpassende Kondensatorstruktur, wo der Zusammenbau der Kontakte und der Metallisierung nur mit Hilfe von Gleichstromtests kontrolliert werden kann, die aufweist:

— eine erste die erste Elektrode (6) bildende und mit einem ersten Kontakt (12b) versehene Leitungsschicht,
— eine zweite die zweite Elektrode (8a) bildende und mit einem zweiten Kontakt (12a) versehene Leitungsschicht,
— eine ein Dielektrikum zwischen den zwei Elektroden bildende Isolierungsschicht (7), dadurch gekennzeichnet, daß sie außerdem aufweist:
— einen dritten Kontakt (12c) mit der ersten Leitungsschicht, der mit dem ersten Kontakt derart zusammenarbeitet, daß er einen Test des Zusammenbaus und des Durchlaufs hinsichtlich des Gleichstromes in der Schicht gestattet,
— einen vierten Kontakt (12d) mit der zweiten Leitungsschicht, der mit dem zweiten Kontakt so zusammenarbeitet, daß er einen Test des Zusammenbaues und des Durchlaufs unter Anwendung des Gleichstroms gestattet.

2. Kondensatorstruktur nach Anspruch 1, dadurch gekennzeichnet, daß die zweite Leitungsschicht die Form eines Mäanders hat, wobei die Kontakte (12a) und (12d) an deren zwei Enden angeordnet sind.

3. Kondensatorstruktur nach Anspruch 1 oder 2, dadurch gekennzeichnet, daß die erste Leitungsschicht eine stark dopierte halbleitende Zone (6) ist, welche in einem isolierten Grabengebiet (4) einer epitaxialen Schicht (3) gebildet ist.

4. Kondensatorstruktur nach Anspruch 3, dadurch gekennzeichnet, daß die erste Schicht auch die Form eines dem der zweiten Schicht entsprechenden Mäanders hat.

**Claims**

1. A capacitor structure able to be integrated according to the monolithic or hybrid technologics the contact and metallurgy integrity of which can be tested only by d.c. tests, of the type including:
a first conductive layer forming first electrode (6) and provided with a first contact (12b),
a second conductive layer forming second electrode (8a) and provided with a second contact (12a),
an insulation layer (7) forming the dielectric region between said electrodes,
characterized in that it further includes:
a third contact (12a) with the first conductive layer cooperating with the first contact to allow integrity and continuity of said layer to be tested by d.c. current and
a fourth contact (12a) with the second conductive layer, cooperating with the second contact to allow integrity and continuity of said layer to be tested by d.c. current.

2. A capacitor structure in accordance with claim 1 characterized in that said second conductive layer has the shape of a serpentine contacts (12a) and (12d) being provided at its two ends.

3. A capacitor structure in accordance with claim 1 or 2 characterized in that said first conductive layer is a heavily doped semiconductive region (6) formed in an isolated pocket (4) of an epitaxial layer (3).

4. A capacitor structure in accordance with claim 3 characterized in that first layer has also the shape of a serpentine corresponding to the shape of the second layer.

# FIG.1

# FIG.2A

# FIG.2B

# FIG.3

FIG. 4